# FASCICULE DE BREVET EUROPEEN

(11) **EP 3 612 503 B1**
(45) Date de publication et mention de la délivrance du brevet: **27.09.2023**
(21) Numéro de dépôt: 18717376.0
(22) Date de dépôt: 16.04.2018
(51) Int. Cl.: C04B 35/628, C04B 35/111, C04B 35/117, C04B 35/119, C04B 35/44, C04B 35/486, C04B 35/488, C04B 35/626, C04B 35/632, C04B 35/634, C04B 35/638, A44C 27/00, G04B 45/00, G04B 19/12, C22C 29/12, G04B 37/22, C23C 14/22, C23C 16/44, C23C 16/455, C04B 111/82, C22C 1/10

(54) **FABRICATION D'UN COMPOSANT EN CÉRAMIQUE**
HERSTELLUNG EINES KERAMIK-BAUTEILS
PRODUCTION OF A CERAMIC COMPONENT

(30) Priorité: 20.04.2017 EP 17167229
(43) Date de publication de la demande: 26.02.2020
(73) Titulaire: ROLEX SA, 1211 Genève 26 (CH)
(72) Inventeur: BOCCARD, Cyriaque, 74140 Douvaine (FR); PUJOL, Ollivier, 1006 Lausanne (CH)
(74) Mandataire: Moinas & Savoye SARL
(86) Numéro de dépôt international: PCT/EP2018/059693
(87) Numéro de publication internationale: WO 2018/192886

(56) Documents cités:
- EP-A1- 0 345 795
- EP-A1- 2 746 242
- EP-A1- 2 746 243
- WO-A1-2016/147208
- GB-A- 2 501 763
- JP-A- H05 270 820
- US-A1- 2003 026 989
- ITOH H ET AL: "MICROSTRUCTURE AND PROPERTIES OF THE SINTERED COMPOSITE PREPARED BYHOT PRESSING OF TIN-COATED ALUMINA POWDER", JOURNAL OF MATERIALS SCIENCE, KLUWER ACADEMIC PUBLISHERS, DORDRECHT, vol. 28, no. 24, 15 décembre 1993 (1993-12-15), pages 6761-6766, XP000415573, ISSN: 0022-2461, DOI: 10.1007/BF00356428
- ENSINGER W ET AL: "Noble metal deposition on aluminum oxide powder surfaces by ion beam sputtering", NUCLEAR INSTRUMENTS & METHODS IN PHYSICS RESEARCH. SECTION B: BEAM INTERACTIONS WITH MATERIALS AND A, ELSEVIER BV, NL, vol. 141, no. 1-4, mai 1998 (1998-05), pages 693-698, XP004440775, ISSN: 0168-583X, DOI: 10.1016/S0168-583X(98)00173-6
- SEBASTIAN BRUST ET AL: "CVD Coating of Oxide Particles for the Production of Novel Particle-Reinforced Iron-Based Metal Matrix Composites", OPEN JOURNAL OF APPLIED SCIENCES, vol. 06, no. 04, 27 avril 2016 (2016-04-27), pages 260-269, XP055417214, ISSN: 2165-3917, DOI: 10.4236/ojapps.2016.64026
- MCCORMICK J ET AL: "Rotary reactor for atomic layer deposition on large quantities of nanoparticles", JOURNAL OF VACUUM SCIENCE AND TECHNOLOGY: PART A, AVS /AIP, MELVILLE, NY., US, vol. 25, no. 1, 2 janvier 2007 (2007-01-02), pages 67-74, XP012102560, ISSN: 0734-2101, DOI: 10.1116/1.2393299

## Description

### Introduction

La présente invention concerne un procédé de fabrication d'une poudre céramique et d'un composant en céramique. Une telle poudre et un tel composant en céramique trouvent des applications dans l'horlogerie, la joaillerie ou la bijouterie. Particulièrement, un tel composant trouve des applications dans une pièce d'horlogerie, notamment pour les composants de décoration, comme une lunette ou des composants fonctionnels, comme des pièces de mouvement.

### Etat de l'Art

Dans le domaine de l'horlogerie, de même que dans la bijouterie ou la joaillerie, il est connu d'utiliser des composants en céramique, notamment des composants de décoration, voir notamment les documents EP2746242 A1 et EP2746243 A1.

Mais une limite dans l'utilisation de ces composants en céramique provient de la difficulté, voire l'impossibilité, à obtenir certaines couleurs, notamment certaines teintes grises, et de la difficulté à obtenir une couleur homogène, prévisible et reproductible. De plus, l'obtention d'une teinte particulière nécessite l'élaboration d'un lot de matière complet à partir des composants initiaux et s'avère chronophage et complexe. Une autre limite provient de même de la difficulté à tester l'effet d'ajouts de certains éléments, qui peuvent se combiner aux constituants de céramiques connues, notamment pour obtenir certaines caractéristiques mécaniques particulières du composant en céramique. Ici également, chaque essai est complexe et nécessite la mise en oeuvre d'un lot de matière complet à partir des composants initiaux.

Le procédé habituel de fabrication d'un composant en céramique comprend une première phase consistant à préparer la matière première, c'est-à-dire la poudre céramique, comme par exemple une poudre céramique à base de zircone et/ou d'alumine. Dans cette première phase, cette matière première est en général préparée sous forme de poudre céramique à laquelle on peut ajouter par exemple d'autres oxydes pour renforcer le composant céramique ou des pigments en vue d'obtenir une matière colorée. Les pigments sont en général du type oxyde métallique ou oxyde de terre rare, et sont ajoutés et mélangés à la poudre céramique de base par voie liquide, les pigments étant ainsi introduits par un liquide porteur.

Une deuxième phase du procédé de fabrication d'un composant en céramique consiste à intégrer un liant à la poudre céramique obtenue par la première phase. Un tel liant est en général constitué d'un ou plusieurs composés organiques. La nature et la proportion du liant dépendent du procédé prévu dans une troisième phase, et à l'issue de cette phase on parle de manière générale de poudre céramique liantée.

La troisième phase consiste en une mise en forme du composant en céramique. Pour cela, une première approche comprend une étape de pressage d'un agglomérat de particules liantées obtenues en fin de deuxième phase : dans un tel procédé, la deuxième phase prépare une poudre céramique liantée sous forme de granules atomisés de pressage. Une deuxième approche consiste en une mise en forme par injection dans un moule. Dans un tel cas, la préparation résultant de la deuxième phase est une poudre céramique liantée appelée par sa dénomination anglaise « feedstock ». Une troisième approche consiste en une mise en forme par coulage dans un moule, communément appelée coulage en barbotine. Dans un tel cas, la préparation résultant de la deuxième phase est une poudre céramique liantée en suspension appelée par sa dénomination anglaise « slurry » et barbotine en français. A la fin de la troisième phase, le composant en céramique présente une forme qui se rapproche de sa forme finale et contient à la fois la poudre céramique et le liant. D'autres techniques de mise en forme, comme le gel casting, freeze casting ou encore les techniques de Coagulation Casting peuvent être utilisées.

Une quatrième phase permet de finaliser le composant en céramique. Cette quatrième phase comprend une première étape consistant à délianter le composant, c'est-à-dire à supprimer le liant, par exemple par un traitement thermique ou au moyen d'un solvant. Une deuxième étape permet de densifier le composant en éliminant les pores provenant du déliantage. Cette deuxième étape consiste en général en un traitement thermique de frittage (une cuisson à haute température). La couleur finale du composant en céramique, ainsi que ses propriétés mécaniques finales, apparaissent uniquement à la fin de cette quatrième phase et sont issues des réactions entre les différents constituants du composant mais également de l'atmosphère présente dans le four, qui interviennent lors du traitement thermique. Ces réactions sont complexes et parfois imprévisibles.

On constate que le procédé traditionnel de fabrication d'un composant en céramique, rappelé ci-dessus, présente plusieurs inconvénients. Particulièrement, la couleur et les propriétés finales obtenues dépendent de nombreux paramètres, comme la microstructure de la poudre formée dans la première phase, notamment la taille des grains de céramique, la taille des pigments, leur réactivité avec la céramique et l'environnement de frittage, etc. Elles dépendent de plus de tous les autres facteurs liés aux autres phases de fabrication, comme la taille et le nombre de pores dans le composant final, la composition des joints de grains, la densité, le pourcentage du ou des pigments ainsi que leur répartition dans la matrice, leur éventuelle combinaison entre eux ou avec les constituants de la matière première céramique ou l'atmosphère lors du frittage, la pureté chimique des composés initiaux et l'éventuelle présence de contaminants intrinsèques et extrinsèques.

Cette multiplicité de paramètres à prendre en compte rend difficile la prédictibilité et la reproductibilité d'une certaine couleur qu'on souhaite fabriquer. Cette constatation est d'autant plus vraie si la quantité de pigments de coloration est faible : ainsi, pour réduire cet inconvénient, tous les procédés existants utilisent nécessairement une quantité importante de pigments. De plus, certains procédés tentent d'améliorer le résultat en ajoutant des étapes basées sur de la chimie complexe, ce qui présente naturellement l'inconvénient de complexifier davantage le procédé de fabrication.

D'autre part, la difficulté de gestion des couleurs d'un composant en céramique induit en pratique la nécessité de nombreux essais, comprenant la réalisation de nombreux échantillons complets, de l'élaboration de la poudre céramique jusqu'à la mise en forme finalisée, en variant certains des paramètres susmentionnés pour chaque échantillon afin de déterminer le procédé optimal. De plus, lorsqu'on veut modifier une couleur, même légèrement, il faut recommencer toute l'élaboration intégralement, incluant de nouveau la préparation de nombreux échantillons. La recherche d'une couleur maîtrisée d'un composant en céramique, souvent nécessaire pour son utilisation comme élément de décoration, exige donc des étapes complexes et fastidieuses de mise au point en pratique.

Enfin, malgré les nombreux essais, on constate à ce jour qu'il apparaît impossible d'obtenir des composants en céramique présentant certaines couleurs, notamment certaines couleurs grises comme celles définies par les coordonnées colorimétriques CIE L*a*b* (83 ; 0 ; 0.6) et CIE L*a*b* (47 ; 0.2 ; -0.2). De manière générale, une couleur par exemple définie par des paramètres a* et b* proches de zéro et un paramètre L* inférieur à 96, notamment une couleur strictement grise, est impossible à obtenir.

Le document US2003026989 A1 et l'article "Rotary reactor or atomic layer deposition on large quantifies of nanoparticles" de J.A. McCormick et al., (J. Vac. Sci. Technol. A, 25, 2007, pp. 67-74), décrivent des particules céramiques revêtues à l'aide d'un dépôt par couche atomique (ALD).

Ainsi, le but général de la présente invention est de proposer une solution de fabrication d'un composant en céramique, notamment pour une pièce d'horlogerie, qui ne comprend pas les inconvénients de l'état de la technique. Plus précisément, un premier objet de la présente invention est de proposer une solution de fabrication d'une poudre céramique et d'un composant en céramique qui permet d'obtenir une céramique aux propriétés améliorées, notamment dont la coloration est maîtrisée et/ou notamment dotée de propriétés nouvelles ou optimisées par exemple parmi des propriétés mécaniques, thermiques, électriques, tribologiques.

Un second objet de la présente invention est de proposer une solution de fabrication simplifiée d'un composant en céramique coloré.

Un troisième objet de la présente invention est de proposer une céramique grise.

Un quatrième objet de la présente invention est de proposer une méthode simple de modification d'une poudre céramique potentiellement déjà colorée pour modifier la couleur résultante du composant céramique terminé.

### Brève description de l'invention

A cet effet, l'invention repose sur un procédé de fabrication d'un composant en céramique, notamment à base de zircone et/ou d'alumine et/ou d'aluminate de strontium, pour pièce d'horlogerie ou de joaillerie, caractérisé en ce qu'il comprend une étape de dépôt d'au moins un élément ou composé additionnel sur une poudre céramique, liantée ou non, par un dépôt par couche atomique (ALD), potentiellement suivi par d'autres dépôts par couche atomique (ALD) et/ou dépôt chimique en phase vapeur (CVD) et/ou dépôt physique en phase vapeur (PVD).

L'invention est plus précisément définie par les revendications.

### Brève description des figures

Ces objets, caractéristiques et avantages de la présente invention seront exposés en détail dans la description suivante d'un mode de réalisation particulier fait à titre non-limitatif en relation avec les figures jointes parmi lesquelles :
La figure 1 représente schématiquement un logigramme des étapes du procédé de fabrication d'un composant en céramique coloré pour pièce d'horlogerie selon un mode de réalisation de la présente invention.
La figure 2 représente la microstructure d'un composant en céramique obtenu selon un premier exemple selon un mode de réalisation de l'invention.
La figure 3 représente la microstructure d'un composant en céramique obtenu selon un deuxième exemple selon un mode de réalisation de l'invention.
La figure 4 consiste en un tableau de résultats de composants en céramique obtenus selon des exemples de mise en oeuvre d'un mode de réalisation de l'invention.

Par la suite, nous désignerons par composant ou poudre céramique un composant ou une poudre obtenu dans un matériau dense polycristallin comprenant principalement au moins une céramique, notamment à base de zircone et/ou d'alumine et/ou d'aluminate de strontium, par exemple une zircone stabilisée à l'oxyde d'yttrium et/ou de cérium et/ou de magnésium et/ou de calcium. On désignera par poudre céramique une poudre sous forme de solide finement divisé, composée de fines particules de céramique, notamment à base de zircone et/ou d'alumine et/ou d'aluminate de strontium. Pour simplifier la description, nous conserverons volontairement de manière élargie le même terme de poudre céramique pour une poudre comprenant principalement des fines particules de céramique, mais aussi d'autres éléments ajoutés comme par exemple un ou plusieurs pigments ou des oxydes visant à renforcer la céramique, tels que l'oxyde d'yttrium. De manière similaire, nous désignerons par composant céramique un composant par exemple obtenu par frittage d'une telle poudre céramique. Ainsi, la poudre ou composant céramique comprend dans tous les cas majoritairement une composante de type céramique, soit au moins 50% en poids de cette composante de type céramique, voire au moins 75%, voire au moins 90%. Par exemple, la poudre ou composant céramique comprend au moins 50% en poids de zircone.

Dans tous les cas, une poudre céramique ne contient pas de composé organique. Nous désignerons par le terme générique de poudre céramique liantée un matériau composite constitué par une poudre céramique et un liant, généralement constitué par un ou plusieurs composés organiques, dans des proportions variables, destiné à la mise en forme d'une pièce par pressage, par injection, par coulage ou par d'autres techniques.

Nous désignerons par granule (de pressage) un agglomérat de poudre céramique liantée, destiné à une mise en forme par un procédé de pressage, par exemple un pressage uniaxial à froid ou à chaud ou un pressage isostatique à froid ou à chaud. Un granule comprend en général entre 1% et 4% inclus en poids de composés organiques.

Nous désignerons par le terme de poudre céramique injectable, aussi généralement dénommée par le terme anglo-saxon de « feedstock », une poudre céramique liantée destinée à une mise en forme par un procédé d'injection, haute ou basse pression. Une poudre céramique injectable comprend en général entre 12 et 25% inclus en poids de composés organiques.

Nous désignerons par le terme de « slurry » une poudre céramique liantée destinée à une mise en forme par coulage en barbotine ou par gel-casting. Un slurry comprend en général entre 1 % et 25% inclus en poids de composés organiques.

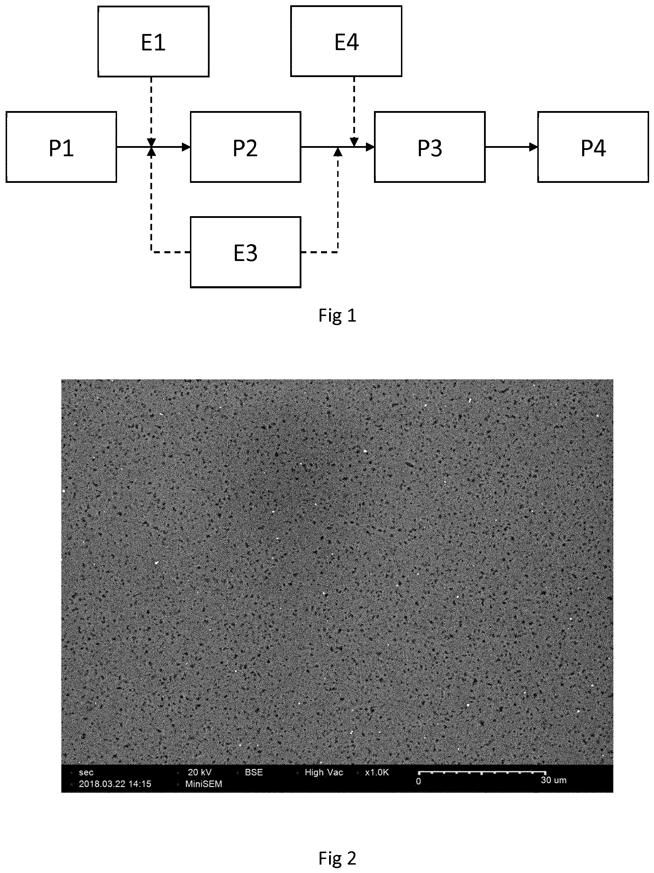

Le procédé de fabrication d'un composant céramique selon un mode de réalisation de l'invention comprend les phases et les étapes schématiquement représentées par le logigramme de la figure 1.

Ce procédé de fabrication comprend donc les phases habituelles P1 à P4 du procédé, à savoir la préparation de la poudre céramique (P1), l'ajout d'un liant (P2), la mise en forme du composant (P3) et le traitement thermique de déliantage-frittage (P4). Les parties traditionnelles de ces phases ne seront pas détaillées à ce stade puisqu'elles sont connues de l'état de la technique. L'homme du métier saura donc les mettre en oeuvre, y compris selon toutes les variantes ou équivalences existantes.

Le mode de réalisation de l'invention se distingue particulièrement du procédé traditionnel par l'ajout d'une étape de dépôt E3 d'au moins un élément ou composé additionnel, par exemple un élément de coloration, par voie sèche, par un dépôt par couche atomique, connu par le sigle ALD pour l'expression anglo-saxonne de « Atomic Layer Déposition ».

Cette étape de dépôt E3 est mise en oeuvre sur une poudre céramique, liantée ou non, donc après la première phase P1 ou après la deuxième phase P2 du procédé de fabrication. Elle peut donc être mise en oeuvre sur une poudre céramique ne comprenant que des particules de céramique ou sur une poudre céramique comprenant des composés organiques, par exemple sur un granule ou sur du feedstock d'injection. Elle est mise en oeuvre avant la troisième phase P3 du procédé. Pour simplifier la description, nous continuerons d'appeler poudre céramique, liantée ou non, la poudre céramique comprenant un ou plusieurs élément(s) ou composé(s) additionnel(s), obtenue par la mise en oeuvre de l'étape de dépôt E3 de l'invention.

L'élément ou composé additionnel peut être très varié, particulièrement un métal, et/ou un oxyde, et/ou un nitrure et/ou un carbure. Nous entendons par métal, un métal pur ou un alliage. Il peut donc être avantageusement un composé à base métallique. A des fins de simplification, nous utiliserons dans la suite du document les termes d'élément additionnel ou de composé additionnel sans distinction, tant pour un élément seul que pour un composé ou un alliage.

De manière nouvelle, l'invention permet aussi l'utilisation de métaux qui ne pouvaient pas être utilisés avec les solutions existantes, comme les métaux nobles à haut point de fusion, supérieur ou égal à 1200° C, voire supérieur ou égal à 1500° C. Ainsi, l'invention permet d'utiliser comme élément additionnel le platine, et/ou le rhodium, et/ou l'osmium, et/ou le palladium, et/ou le ruthénium, et/ou l'iridium. En variante, d'autres métaux peuvent être utilisés, et on peut compléter la liste précédente par l'or, l'aluminium, l'argent, le rhénium, le titane, le tantale ou le niobium. En complément, les métaux de transition caractérisés par une couche d incomplète, selon la liste ci-après, permettent d'obtenir un résultat particulièrement inédit et intéressant du fait de leur ajout selon l'étape de dépôt E3 particulière de l'invention : le fer, le chrome, le vanadium, le manganèse, le cobalt, le nickel et le cuivre. De même, les lanthanides (La, Ce, Pr, Nd, Pm, Sm, Eu, Gd, Tb, Dy, Ho, Er, Tm, Yb et Lu) permettent de doper les poudres céramiques liantées ou non lors de l'étape E3 et d'obtenir des couleurs et/ou des propriétés intéressantes. Comme mentionné ci-dessus, le composé additionnel peut donc être un alliage comprenant ou constitué d'un ou de plusieurs des métaux et lanthanides listés ci-dessus.

Ainsi, un composé additionnel peut être un composé ou alliage métallique, obtenu par le dépôt direct de l'alliage métallique sur la poudre céramique liantée ou non, ou par la combinaison de dépôts successifs ou simultanés de plusieurs des éléments de l'alliage métallique sur la poudre céramique, liantée ou non.

De manière similaire, un composé additionnel peut être un oxyde, un carbure ou un nitrure d'un ou de plusieurs métaux, obtenu par le dépôt direct de l'oxyde, du carbure, du nitrure sur la poudre céramique liantée ou non, ou par la réaction d'un dépôt métallique avec une atmosphère réactive, notamment dans l'enceinte de dépôt ou ultérieurement au dépôt, par exemple lors d'une étape de frittage du composé en céramique.

Naturellement, plusieurs éléments ou composés additionnels différents peuvent être utilisés et déposés sur la même poudre céramique, simultanément ou successivement, par une ou plusieurs étapes de dépôt E3 telles que décrites ci-dessus. Cette augmentation des composés additionnels disponibles permet naturellement d'augmenter les couleurs possibles pour une céramique, ainsi que les autres propriétés possibles, notamment mécaniques ou tribologiques.

En remarque, l'homme du métier a l'habitude d'ajouter des pigments de couleur par voie liquide dans une céramique. Il n'est pas habitué à agir par voie sèche, ni à faire un dépôt directement sur une poudre céramique, liantée ou non. Lors d'un tel dépôt sous vide par voie sèche, les paramètres suivants sont à considérer :
- L'homogénéité du dépôt sur les poudres,
- L'homogénéité de forme et de taille des grains de la poudre,
- Les températures du procédé,
- Le risque de dégazage,
- Le caractère électrostatique des solides divisés en mouvement (isolants),
- L'état de finition et la nature des matériaux de l'équipement ; il faut notamment bien choisir le couple entre la nature du dépôt et la nature des liants des granules pour éviter le collage de la poudre sur l'équipement.

On s'aperçoit que le procédé de l'invention permet d'atteindre des résultats très satisfaisants, au niveau des propriétés nouvelles ou améliorées des composants en céramique, même avec des quantités très faibles de composé additionnel ajouté à la céramique. Ainsi, la couleur d'un composant en céramique est non seulement améliorée par rapport aux solutions existantes en ce qu'elle est homogène et/ou peut permettre des teintes nouvelles, mais en plus, ce résultat amélioré est obtenu par l'ajout d'un élément ou composé additionnel de coloration en très faible quantité, notamment en quantité nettement inférieure à la quantité de pigments de coloration utilisée avec les méthodes traditionnelles.

Par exemple, le procédé de dépôt ALD est utilisé pour obtenir des teneurs en poids d'élément(s) ou de composé(s) additionnel(s) inférieures ou égales à 3%, mais aussi notamment inférieures ou égales à 2%, voire inférieures ou égales à 1%, voire inférieures ou égales à 0,05%, voire inférieures ou égales à 0,01%. En remarque, toutes les teneurs en poids sont mesurées sur le composant en céramique terminé (après réalisation de la quatrième phase du procédé de fabrication) ou sur la poudre céramique déliantée, c'est-à-dire en dehors de la considération du poids du liant. Avantageusement, ces teneurs sont supérieures ou égales à 1 ppm. Avantageusement, ces teneurs sont comprises entre 1 ppm et 0,01% inclus, voire entre 1 ppm et 0,05% inclus, voire entre 1 ppm et 3% inclus. L'invention présente donc l'avantage d'obtenir des résultats très intéressants avec une faible quantité de matière de composé additionnel, voire une très faible quantité de matière, sans recourir à l'élaboration d'un lot complet à chaque fois, et en permettant de surcroît de modifier un lot de base par itérations.

Il est de plus important de souligner que le procédé de l'invention permet d'obtenir une répartition homogène ou une bonne dispersion d'un composé additionnel, et donc finalement d'obtenir un composant en céramique de propriété (par exemple couleur) homogène. Si le dépôt d'un élément additionnel est effectué sur une poudre céramique, donc avant la réalisation de la deuxième phase du procédé, la poudre céramique ainsi enrichie subit une succession d'étapes de dispersion/broyage en voie liquide lors de la deuxième phase P2, pour la lianter avec un composé organique, avant de l'atomiser pour en faire par exemple des granules en fin de deuxième phase P2 du procédé. Cette deuxième phase P2 permet ainsi de répartir de manière homogène le composé additionnel. En variante, si le composé additionnel est déposé après la deuxième phase P2 du procédé, donc par exemple directement sur des granules, le composé additionnel se trouve réparti en surface des granules du fait du procédé de dépôt utilisé, et est ainsi réparti de manière homogène sur la poudre céramique liantée. Le composé additionnel se retrouvera réparti de manière homogène dans le composant en céramique fritté terminé.

La conformité du dépôt ALD permet de répartir le revêtement sur la poudre, et dans le cas d'un revêtement métallique, la poudre devient moins électrostatique. Elle s'agglomère moins.

Dans les deux cas précédents, l'analyse du corps obtenu en fin de la quatrième phase (P4) montre que la répartition homogène du composé additionnel est conservée dans le composant en céramique finalisé. Si le dépôt a été effectué sur la poudre céramique, il apparaît une répartition finale des particules de composé additionnel dans la microstructure céramique aléatoire et microscopiquement homogène. Dans le cas de dépôts sur le feedstock d'injection, l'homogénéisation de la répartition des particules du composé additionnel dans le matériau a notamment lieu lors de l'étape de plastification du mélange fondu par la vis d'injection. Ainsi, dans tous les cas, le composant en céramique comprend un élément additionnel réparti de manière homogène dans son volume, ce qui lui permet de présenter la propriété induite par cet élément additionnel réparti de manière homogène dans le composant en céramique.

Finalement, l'étape de dépôt E3 du mode de réalisation de l'invention apporte les avantages principaux suivants :
- Elle permet d'obtenir un ajout d'un élément ou composé additionnel parfaitement maîtrisé en termes de composition et de quantité et en très faible quantité, et permet donc de mettre en oeuvre un microdosage du composé ou élément additionnel ;
- Elle permet d'obtenir in fine une répartition homogène du composé additionnel dans le composant céramique ;
- Elle permet l'ajout d'une multitude de composés additionnels, augmentant le nombre de composés additionnels possibles, par rapport aux solutions existantes, augmentant les possibilités pour doter un composant en céramique de certaines propriétés ;
- Elle permet un dépôt fiable, répétable et propre d'un composé additionnel.

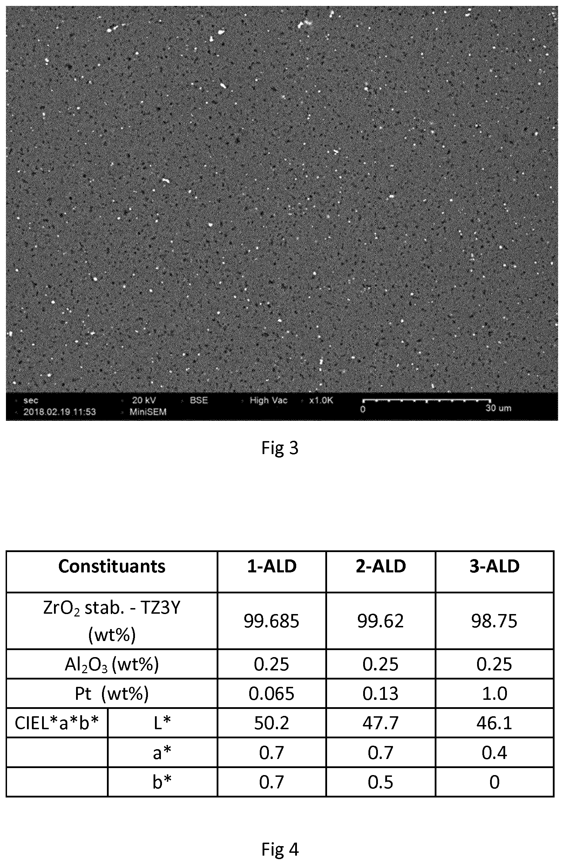

L'invention est illustrée ci-dessous par des exemples qui permettent de fabriquer un composant en céramique grise, selon des teintes impossibles à fabriquer avec les techniques traditionnelles. Tous les résultats obtenus, notamment en termes de couleur, sont résumés dans le tableau de la figure 4.

Le premier exemple repose sur l'utilisation d'une poudre céramique, non liantée, composée de zircone yttriée à 3 %molaire (TZ3YS). 40 grammes de cette poudre sont placés dans le bol vibrant d'une enceinte ALD, qui est mise sous vide, afin d'engager le dépôt de platine par le procédé ALD. 100 cycles de dépôt sont réalisés.

La poudre céramique ainsi revêtue subit ensuite un traitement d'attrition (mélange, broyage en voie liquide) et de liantage. Dans ce traitement, 0.48 g de PVA, 0.71 g de PEG 20 000, et 150 ml d'eau déionisée sont ajoutés à 39.7 g de ladite poudre céramique, recouverte de platine. La suspension ainsi obtenue est placée dans le bol en zircone d'un attriteur avec 1 kg de billes de zircone, pour être attritée/broyée durant 2 heures à 400 tour/minute. La suspension est ensuite recueillie pour être séchée et granulée par atomisation à l'aide d'un « Spray Dryer ». Les granules ainsi obtenus sont ensuite pressés dans un moule cylindrique sur une presse uniaxiale. La pastille ainsi obtenue est déliantée sous air puis frittée à 1450 °C. A l'issue du frittage, les faces de la pastille en céramique sont rectifiées puis polies. Le composant en céramique obtenu est de couleur grise. La couleur résultante apparaît homogène à l'oeil nu. La couleur et la composition sont données dans le tableau de la figure 4 sous la référence 1-ALD.

Le second exemple repose sur l'utilisation d'une poudre céramique, non liantée, composée de zircone yttriée à 3 %molaire (TZ3YS). 10 grammes de cette poudre sont placés dans le bol vibrant d'une enceinte ALD, qui est mise sous vide, afin d'engager le dépôt de platine par le procédé ALD. 50 cycles de dépôt sont réalisés.

La poudre céramique ainsi revêtue subit ensuite un traitement d'attrition (mélange, broyage en voie liquide) et de liantage. Dans ce traitement, 0.48 g de PVA, 0.72 g de PEG 20 000, et 150 ml d'eau déionisée sont ajoutés à 40.0 g de ladite poudre céramique, recouverte de platine. La suspension ainsi obtenue est placée dans le bol en zircone d'un attriteur avec 1 kg de billes de zircone, pour être attritée/broyée durant 2 heures à 400 tour/minute. La suspension est ensuite recueillie pour être séchée et granulée par atomisation à l'aide d'un « Spray Dryer ». Les granules ainsi obtenus sont ensuite pressés dans un moule cylindrique sur une presse uniaxiale. La pastille ainsi obtenue est déliantée sous air puis frittée à 1450 °C. A l'issue du frittage, les faces de la pastille en céramique sont rectifiées puis polies. Le composant en céramique obtenu est de couleur grise. La figure 2 est une image obtenue au microscope électronique à balayage (MEB) de la pastille en céramique frittée, qui montre la répartition des particules de platine (points clairs). Cette figure permet de mettre en évidence la répartition homogène des particules de platine. En effet, à l'échelle du composant, nous considérons la répartition de ces particules comme homogène. La couleur résultante apparaît homogène à l'oeil nu. La couleur et la composition sont données dans le tableau de la figure 4 sous la référence 2-ALD.

Le troisième exemple repose sur l'utilisation d'une poudre céramique, non liantée, composée de zircone yttriée à 3 % molaire (TZ3YS). 10 grammes de cette poudre sont placés dans le bol vibrant d'une enceinte ALD, qui est mise sous vide, afin d'engager le dépôt de platine par le procédé ALD. 200 cycles de dépôt sont réalisés. La poudre céramique ainsi revêtue subit ensuite un traitement d'attrition (mélange, broyage en voie liquide) et de liantage. Dans ce traitement, 0.6 g de PVA, 0.9 g de PEG 20 000, et 116 ml d'eau déionisée sont ajoutés à 50.1 g de ladite poudre céramique, recouverte de platine. La suspension ainsi obtenue est placée dans le bol en zircone d'un attriteur avec 1 kg de billes de zircone, pour être attritée/broyée durant 2 heures à 400 tour/minute.

La suspension est ensuite recueillie pour être séchée et granulée par atomisation à l'aide d'un « Spray Dryer ». Les granules ainsi obtenus sont ensuite pressés dans un moule cylindrique sur une presse uniaxiale. La pastille ainsi obtenue est déliantée sous air puis frittée à 1450 °C. A l'issue du frittage, les faces de la pastille en céramique sont rectifiées puis polies. Le composant en céramique obtenu est de couleur grise. La figure 3 est une image obtenue au microscope électronique à balayage (MEB) de la pastille en céramique frittée, qui montre la répartition des particules de platine (points clairs). Cette figure permet de mettre en évidence la répartition homogène des particules de platine. En effet, à l'échelle du composant, nous considérons la répartition de ces particules comme homogène. La couleur résultante apparaît homogène à l'oeil nu. La couleur et la composition sont données dans le tableau de la figure 4 sous la référence 3-ALD.

Le tableau de la figure 4 représente les résultats des exemples précédents. Il est intéressant de constater que tous ces exemples permettent d'obtenir une céramique grise. Ainsi, de manière générale, un mode de réalisation de l'invention permet avantageusement de fabriquer une céramique grise, caractérisée par les deux paramètres a* et b* compris entre -1 et 1 inclus.

En variante, un mode de réalisation de l'invention peut permettre de fabriquer un composant en céramique grise, caractérisée par les deux paramètres a* et b* compris entre -3 et 3 inclus, voire entre -2 et 2 inclus, voire entre -0,5 et 0,5 inclus.

En remarque, l'attrition après l'ajout du platine permet de mieux répartir le platine dans la matière et ne modifie pas significativement la couleur de la céramique obtenue dans ces exemples. On constate également une très légère augmentation de la densité des échantillons liée à l'attrition. Cette attrition reste toutefois optionnelle.

Naturellement, l'invention ne se limite pas à la fabrication d'un composant en céramique contenant du platine comme composé additionnel. Il est possible d'obtenir une couleur grise avec un autre composé additionnel que le platine par exemple avec du rhodium, du palladium ou tout autre métal noble gris ne réagissant pas avec les autres composants de la céramique ou l'atmosphère de frittage. De plus, l'invention ne se limite pas à la fabrication d'un composant en céramique d'une certaine couleur. Il est en effet possible d'obtenir de nombreuses couleurs en variant le composé additionnel. On constate que l'ajout de fer Fe donne une céramique très légèrement jaune. L'ajout de chrome Cr sur une zircone stabilisée pure donne également une céramique jaune avec une légère tendance rouge. Le chrome déposé sur une zircone additionnée d'alumine de teneur 2 % en poids donne une matière plus claire, mais plus rouge. L'ajout de vanadium V rend la céramique jaune et l'ajout d'aluminium Al est quasi sans effet sur la couleur de base.

De manière optionnelle, le procédé de fabrication peut comprendre une étape préalable E1 d'ajout d'un autre composé à la poudre de céramique liantée ou non, par exemple l'ajout de pigments de coloration ou tout autre composé selon l'approche traditionnelle rappelée précédemment ou selon d'autres techniques connues de l'homme du métier, par exemple par précipitation de sels. En effet, l'invention reste compatible avec tous les autres procédés existants, et peut venir en complément, par exemple pour l'enrichir. Cette étape E1 peut être réalisée à tout moment opportun du procédé de fabrication. Elle peut être réalisée avant ou après l'étape E3.

Selon une autre variante et de manière optionnelle, le procédé de fabrication peut comprendre une étape postérieure E4 d'ajout d'un autre élément ou composé additionnel à la poudre céramique liantée, après l'étape de dépôt E3 décrite précédemment. Dans ce cas, l'étape de dépôt E3 par le procédé ALD peut permettre de rendre la surface d'une poudre céramique conductrice, par exemple en ajoutant un composé additionnel métallique. Ceci offre l'avantage de limiter les risques d'agglomération de la poudre céramique, notamment au sein d'une enceinte PVD pour procéder à un dépôt physique en phase vapeur, connu par le sigle PVD pour l'expression anglo-saxonne de « Physical Vapor Deposition », puisque les particules de cette poudre céramique ont un caractère électrostatique qui tend à les rapprocher et à former naturellement des agglomérats, ce qui est désavantageux pour leur enrobage ultérieur avec un composé additionnel. En remarque, ce premier composé additionnel conducteur n'a pas besoin de recouvrir la surface totale des grains de poudre pour être efficace. En remarque, cet autre composé additionnel, déposé par toute technique, PVD, CVD « Chimical Vapor Déposition » ou ALD, peut être identique à celui qui a été déposé par le dépôt ALD. En variante, les deux composés additionnels déposés diffèrent, pour combiner leurs propriétés.

Comme cela a été mentionné précédemment, la solution de l'état de la technique pour colorer un composant en céramique est complexe et n'est pas toujours satisfaisante. D'autre part, lorsqu'on souhaite modifier une teinte, même légèrement, d'un composant en céramique préalablement coloré à l'aide de pigments selon l'état de la technique, il apparaît très difficile de le faire avec la technique traditionnelle, notamment parce que les pigments ont tendance à réagir entre eux lors du frittage. Ainsi, selon l'état de la technique, il est long et fastidieux de modifier l'intensité (clarté) et/ou la teinte de la coloration d'une céramique colorée : en effet, chaque tentative nécessite la réalisation d'un nouveau lot de poudre céramique ayant une nouvelle composition chimique, puis la fabrication d'un feedstock d'injection, et jusqu'à la réalisation des composants céramiques terminés (frittés et polis).

Avec le procédé de l'invention, il devient beaucoup plus facile de réaliser une telle modification de couleur ou d'intensité. Plus généralement, toute autre modification de propriété du composant en céramique devient facilement réalisable.

Ainsi, un mode de réalisation de l'invention repose sur un procédé de fabrication d'un composant en céramique, notamment à base de zircone et/ou d'alumine et/ou d'aluminate de strontium, qui comprend les étapes suivantes :
- Se munir d'une poudre céramique liantée, obtenue selon le procédé décrit précédemment, contenant des pigments de coloration ou plus généralement d'au moins un composé ajouté ou additionnel qui permettraient d'obtenir un composant en céramique d'une première couleur ou plus généralement doté d'une première propriété par fabrication d'un composant en céramique à partir de cette poudre céramique liantée ;
- Déposer E3-E4 au moins un élément ou composé additionnel, de coloration ou autre, sur ladite poudre céramique liantée par un dépôt physique en phase vapeur PVD et/ou par un dépôt chimique en phase vapeur CVD et/ou par un dépôt par couche atomique ALD ;
- Finaliser la fabrication du composant en céramique à partir de la poudre céramique liantée incluant le composé additionnel déposé afin d'obtenir un composant en céramique dont la couleur est une deuxième couleur, différente de la première couleur, ou plus généralement doté d'une deuxième propriété, différente de la première propriété.

Par un tel procédé, une première propriété obtenue à partir d'une poudre céramique liantée peut être facilement modifiée en une poudre liantée ayant une deuxième propriété par l'ajout d'un composé additionnel selon un mode de réalisation de l'invention. Comme ce mode de réalisation de l'invention met en oeuvre une étape E3 facile à implémenter, à maîtriser et à reproduire, il devient aisé de procéder à plusieurs essais pour obtenir par tâtonnement la propriété finale souhaitée pour le composant en céramique, sans exiger une intervention fastidieuse au niveau de l'élaboration d'une poudre céramique.

Ainsi, le procédé de fabrication d'un composant en céramique peut répéter des étapes de dépôt d'au moins un composé additionnel sur ladite poudre céramique liantée, en modifiant la teneur dudit composé additionnel, voire le composé additionnel lui-même, et de finalisation de la fabrication du composant en céramique, jusqu'à s'approcher suffisamment du résultat souhaité.

En pratique, il est donc possible de mettre en oeuvre une étape de sélection d'une poudre céramique liantée contenant des pigments de coloration permettant d'obtenir une première couleur s'approchant d'une deuxième couleur souhaitée, puis de modifier la couleur par l'ajout d'un composé additionnel de coloration, jusqu'à s'approcher suffisamment de la couleur souhaitée. La même approche peut être mise en oeuvre pour modifier toute autre propriété que la couleur, comme mentionné précédemment.

Avantageusement, le au moins un composé additionnel est choisi non réactif avec les composés ajoutés déjà présents dans la poudre céramique liantée, par exemple des pigments de coloration.

Les pigments présents dans la poudre céramique liantée peuvent comprendre un ou plusieurs éléments parmi un oxyde métallique, et/ou un oxyde de terre rare, et/ou un aluminate de cobalt, et/ou des pigments phosphorescents.

De manière plus générale, le mode de réalisation de l'invention est simplement compatible avec toutes les autres techniques d'ajout d'au moins un composé à une poudre céramique liantée ou non. Ainsi, l'invention peut être combinée à toute autre technique, notamment à une approche traditionnelle, pour obtenir toute sorte de céramique aux propriétés nouvelles.

De plus, la coloration d'un composant en céramique est particulièrement importante pour une pièce d'horlogerie ou de joaillerie, parce qu'elle permet d'obtenir une esthétique souhaitée. Ainsi, l'invention est particulièrement intéressante pour fabriquer un composant horloger ou de joaillerie. Ce composant horloger peut notamment être une lunette de montre, un cadran, un index, une couronne de remontoir, un poussoir ou tout autre élément d'habillage horloger ou d'un mouvement horloger. Il est également décrit une pièce d'horlogerie, notamment une montre, comprenant un tel composant horloger.

Naturellement, l'invention ne se limite pas à une couleur particulière, ni à une propriété donnée d'un composant en céramique. En effet, le concept de l'invention est de multiplier et simplifier l'enrichissement possible d'un composant en céramique, et l'invention rend finalement possible la fabrication d'une multitude de nouveaux composants en céramique.

Notamment, un composant en céramique obtenu par un mode de réalisation de l'invention comprend au moins une propriété particulière obtenue par une quantité très faible d'un composé additionnel réparti dans le composant en céramique. Cette quantité très faible est inférieure ou égale à 3% en poids, ou inférieure ou égale à 1% en poids, ou inférieure ou égale à 0,05% en poids, ou inférieure ou égale à 0,01% en poids, rapporté à la masse totale du composé en céramique finalisé. Cette quantité sera de plus avantageusement supérieure ou égale à 1 ppm, ou supérieure ou égale à 10 ppm en dehors du ou des composé(s) organique(s).

De plus, il est également décrit un dispositif de fabrication d'un composant en céramique caractérisé en ce qu'il met en oeuvre le procédé de fabrication d'un composant en céramique. Pour cela, le dispositif de fabrication comprend une chambre pour effectuer un dépôt par couche atomique (ALD), et optionnellement un dépôt physique en phase vapeur (PVD) ou un dépôt chimique en phase vapeur (CVD).

## Revendications

1. Procédé de fabrication d'un composant en céramique pour pièce d'horlogerie ou de joaillerie, **caractérisé en ce qu'**il comprend :
a) une première phase (P1) consistant à préparer une poudre céramique, ladite poudre céramique étant notamment à base de zircone et/ou d'alumine et/ou d'aluminate de strontium,
b) une étape de dépôt (E3) comprenant le dépôt d'au moins un élément ou composé additionnel sur ladite poudre céramique par un dépôt par couche atomique (ALD),
c) une deuxième phase (P2), avant ou après l'étape de dépôt (E3), consistant à intégrer un liant de type organique à la poudre céramique pour former une poudre céramique liantée,
et caractérisé en qu'après les phases (P1) et (P2) de fabrication d'une poudre céramique et d'intégration d'un liant et après l'étape de dépôt (E3) comprenant le dépôt d'au moins un élément ou composé additionnel, le procédé de fabrication met en oeuvre :
d) une troisième phase (P3) de mise en forme provisoire de la poudre céramique liantée comprenant le au moins un composé additionnel, puis
e) une quatrième phase (P4) comprenant une étape de déliantage du composant en céramique en forme provisoire consistant notamment en la suppression des composés organiques puis une étape de frittage du composant en céramique.

2. Procédé de fabrication d'un composant en céramique selon la revendication précédente, **caractérisé en ce que** l'étape de dépôt (E3) comprend l'ajout du au moins un élément ou composé additionnel en quantité totale dans la poudre céramique, en dehors d'éventuel(s) composé(s) organique(s), inférieure ou égale à 3% en poids, ou inférieure ou égale à 1% en poids, ou inférieure ou égale à 0,05% en poids, ou inférieure ou égale à 0,01% en poids en dehors du ou des composé(s) organique(s).

3. Procédé de fabrication d'un composant en céramique selon l'une des revendications précédentes, **caractérisé en ce que** l'étape de dépôt (E3) comprend l'ajout du au moins un composé ou élément additionnel en quantité totale supérieure ou égale à 1 ppm, ou supérieure ou égale à 10 ppm en dehors du ou des composé(s) organique(s).

4. Procédé de fabrication d'un composant en céramique selon l'une des revendications précédentes, **caractérisé en ce que** l'étape de dépôt (E3) comprend le dépôt d'un composé additionnel choisi parmi un métal, et/ou un alliage métallique, et/ou un oxyde, et/ou un nitrure et/ou un carbure.

5. Procédé de fabrication d'un composant en céramique selon la revendication précédente, **caractérisé en ce que** l'élément ou le composé additionnel est ou comprend au moins un métal choisi parmi l'une au moins des quatre listes suivantes :
- un métal noble à haut point de fusion, choisi parmi le platine, le rhodium, l'osmium, le palladium, le ruthénium, ou l'iridium, ou
- tout autre métal choisi parmi l'or, l'aluminium, l'argent, le rhénium, le titane, le tantale ou le niobium, ou
- un métal de transition choisi parmi l'aluminium, le fer, le chrome, le vanadium, le manganèse, le cobalt, le nickel ou le cuivre.
- un lanthanide choisi parmi le lanthane, le cérium, le praséodyme, le néodyme, le prométhium, le samarium, l'europium, le gadolinium, le terbium, le dysprosium, l'holmium, l'erbium, le thulium, l'ytterbium ou le lutécium.

6. Procédé de fabrication d'un composant en céramique selon l'une des revendications précédentes, **caractérisé en ce que** le composé additionnel est un alliage métallique, obtenu par le dépôt direct de l'alliage métallique sur la poudre céramique, liantée ou non, ou par la combinaison de dépôts successifs ou simultanés de plusieurs des éléments de l'alliage ou composé métallique sur la poudre céramique, liantée ou non.

7. Procédé de fabrication d'un composant en céramique selon l'une des revendications 1 à 6, **caractérisé en ce que** le composé ou élément additionnel est un oxyde, un carbure ou un nitrure d'un ou de plusieurs métaux, obtenu par le dépôt direct de l'oxyde, du carbure, du nitrure sur la poudre céramique, liantée ou non, ou par la réaction d'un dépôt métallique avec une atmosphère réactive, notamment dans l'enceinte de dépôt ou ultérieurement au dépôt, par exemple lors d'une étape de frittage du composé en céramique.

8. Procédé de fabrication d'un composant en céramique selon l'une des revendications précédentes, **caractérisé en ce que** l'étape de dépôt (E3) comprend le dépôt simultané ou successif de plusieurs éléments ou composés additionnels différents.

9. Procédé de fabrication d'un composant en céramique selon l'une des revendications précédentes, **caractérisé en ce que** l'étape de dépôt (E3) comprend l'ajout d'au moins un élément ou composé additionnel sur une poudre céramique liantée, comprenant un composé organique en quantité comprise entre 1% et 4% inclus en poids ou comprise entre 12% et 25% inclus en poids, ou comprise entre 1% et 25% inclus en poids, ou sur une poudre céramique ne comprenant pas de composé organique.

10. Procédé de fabrication d'un composant en céramique selon l'une des revendications précédentes, **caractérisé en ce qu'**il comprend, après l'étape de dépôt (E3), une autre étape de dépôt (E4) comprenant le dépôt d'au moins un autre élément ou composé additionnel, identique ou différent dudit au moins élément ou composé additionnel, sur ladite poudre céramique par un dépôt physique en phase vapeur (PVD) et/ou par un dépôt chimique en phase vapeur (CVD) et/ou par un dépôt par couche atomique (ALD).

11. Procédé de fabrication d'un composant en céramique selon l'une des revendications précédentes, **caractérisé en ce qu'**il comprend une étape consistant à ajouter des pigments de coloration, ou des pigments phosphorescents à la poudre céramique, liantée ou non, avant ou après une étape de dépôt (E3) d'au moins un composé additionnel, notamment un composé de coloration différent des pigments de coloration initialement ajoutés.

12. Procédé de fabrication d'un composant en céramique selon l'une des revendications précédentes, **caractérisé en ce qu'**il comprend les étapes suivantes :
- Se munir d'une poudre céramique liantée contenant des pigments de coloration ou plus généralement au moins un composé ajouté et/ou additionnel qui permettraient d'obtenir un composant en céramique d'une première couleur ou plus généralement doté d'une première propriété par fabrication d'un composant en céramique à partir de cette poudre céramique liantée ;
- Déposer (E3 ; E4) au moins un élément ou composé additionnel sur ladite poudre céramique liantée par un dépôt par couche atomique (ALD) ;
- Finaliser la fabrication du composant en céramique à partir de la poudre céramique liantée incluant l'élément ou le composé additionnel déposé afin d'obtenir un composant en céramique dont la couleur est une deuxième couleur, différente de la première couleur, ou plus généralement doté d'une deuxième propriété, différente de la première propriété.

13. Procédé de fabrication d'un composant en céramique selon la revendication précédente, **caractérisé en ce qu'**il comprend la répétition d'étapes de dépôt d'au moins un élément ou composé additionnel sur ladite poudre céramique liantée, avec plusieurs dépôts différents d'au moins un composé additionnel, en variant la quantité et/ou le composé additionnel, jusqu'à s'approcher suffisamment d'une deuxième couleur ou d'une deuxième propriété souhaitée après finalisation de la fabrication du composant en céramique.

14. Procédé de fabrication d'un composant en céramique selon la revendication 12 ou 13, **caractérisé en ce qu'**il comprend une étape de sélection d'une poudre céramique liantée contenant au moins un composé permettant d'obtenir une première propriété s'approchant d'une deuxième propriété souhaitée.

15. Procédé de fabrication d'un composant en céramique selon l'une des revendications 12 à 14, **caractérisé en ce qu'**il permet de fabriquer une lunette de montre, un cadran, un index, une couronne de remontoir, un poussoir ou tout autre élément d'habillage horloger ou tout élément d'un mouvement horloger.

## Patentansprüche

1. Verfahren zur Herstellung eines Keramikbauteils für eine Uhr oder ein Schmuckstück, **dadurch gekennzeichnet, dass** es umfasst:
a) eine erste Phase (P1), die darin besteht, ein Keramikpulver zuzubereiten, wobei das Keramikpulver insbesondere auf Basis von Zirkon und/oder von Aluminiumoxid und/oder von Strontiumaluminat ist,
b) einen Abscheideschritt (E3), der das Abscheiden mindestens eines zusätzlichen Elements oder einer zusätzlichen Verbindung auf das Keramikpulver durch eine Atomlagenabscheidung (ALD) umfasst,
c) eine zweite Phase (P2), vor oder nach dem Abscheideschritt (E3), die darin besteht, ein Bindemittel vom organischen Typ in das Keramikpulver einzubringen, um ein gebundenes Keramikpulver zu bilden,
und **dadurch gekennzeichnet, dass** das Verfahren nach den Phasen (P1) und (P2) des Herstellens eines Keramikpulvers und des Einbringens eines Bindemittels und nach dem Abscheideschritt (E3), der das Abscheiden mindestens eines zusätzlichen Elements oder einer zusätzlichen Verbindung umfasst, einsetzt:
d) eine dritte Phase (P3) des vorläufigen Informbringens des gebundenen Keramikpulvers, das die mindestens eine zusätzliche Verbindung umfasst, dann
e) eine vierte Phase (P4), die einen Schritt des Entbinderns des Keramikbauteils in der vorläufigen Form, das insbesondere im Beseitigen der organischen Verbindungen besteht, dann einen Schritt des Sinterns des Keramikbauteils umfasst.

2. Verfahren zur Herstellung eines Keramikbauteils nach dem vorhergehenden Anspruch, **dadurch gekennzeichnet, dass** der Abscheideschritt (E3) das Zugeben des mindestens einen zusätzlichen Elements oder der mindestens einen zusätzlichen Verbindung in einer Gesamtmenge in dem Keramikpulver, abgesehen von einer(mehreren) etwaigen organischen Verbindung(en), kleiner oder gleich 3 Gew.-% oder kleiner oder gleich 1 Gew.-% oder kleiner oder gleich 0,05 Gew.-% oder kleiner oder gleich 0,01 Gew.-%, abgesehen von der oder den organischen Verbindung(en), umfasst.

3. Verfahren zur Herstellung eines Keramikbauteils nach einem der vorhergehenden Ansprüche, **dadurch gekennzeichnet, dass** der Abscheideschritt (E3) das Zugeben des mindestens einen zusätzlichen Elements oder der mindestens einen zusätzlichen Verbindung in einer Gesamtmenge größer oder gleich 1 ppm oder größer oder gleich 10 ppm, abgesehen von der oder den organischen Verbindung(en), umfasst.

4. Verfahren zur Herstellung eines Keramikbauteils nach einem der vorhergehenden Ansprüche, **dadurch gekennzeichnet, dass** der Abscheideschritt (E3) das Abscheiden einer zusätzlichen Verbindung umfasst, die unter einem Metall und/oder einer Metalllegierung und/oder einem Oxid und/oder einem Nitrid und/oder einem Carbid gewählt ist.

5. Verfahren zur Herstellung eines Keramikbauteils nach dem vorhergehenden Anspruch, **dadurch gekennzeichnet, dass** das zusätzliche Element oder die zusätzliche Verbindung mindestens ein Metall ist oder umfasst, das aus mindestens einer der vier folgenden Listen gewählt ist:
- ein Edelmetall mit hohem Schmelzpunkt, das unter Platin, Rhodium, Osmium, Palladium, Ruthenium oder Iridium gewählt ist, oder
- ein anderes Metall, das unter Gold, Aluminium, Silber, Rhenium, Titan, Tantal oder Niob gewählt ist, oder
- ein Übergangsmetall, das unter Aluminium, Eisen, Chrom, Vanadium, Mangan, Cobalt, Nickel oder Kupfer gewählt ist,
- ein Lanthanoid, das unter Lanthan, Cer, Praseodym, Neodym, Promethium, Samarium, Europium, Gadolinium, Terbium, Dysprosium, Holmium, Erbium, Thulium, Ytterbium oder Lutetium gewählt ist.

6. Verfahren zur Herstellung eines Keramikbauteils nach einem der vorhergehenden Ansprüche, **dadurch gekennzeichnet, dass** die zusätzliche Verbindung eine Metalllegierung ist und durch direktes Abscheiden der Metalllegierung auf das Keramikpulver, gebunden oder nicht, oder durch die Kombination von aufeinander folgenden oder gleichzeitigen Abscheidungen der Elemente der Metalllegierung oder -verbindung auf das Keramikpulver, gebunden oder nicht, erhalten wird.

7. Verfahren zur Herstellung eines Keramikbauteils nach einem der Ansprüche 1 bis 6, **dadurch gekennzeichnet, dass** die zusätzliche Verbindung oder das zusätzliche Element ein Oxid, ein Carbid oder ein Nitrid eines oder mehrerer Metalle ist und durch direktes Abscheiden des Oxids, des Carbids, des Nitrids auf das Keramikpulver, gebunden oder nicht, oder durch die Reaktion einer metallischen Abscheidung mit einer reaktionsfreudigen Atmosphäre, insbesondere in der Abscheidekammer oder nach dem Abscheiden, zum Beispiel bei einem Schritt des Sinterns der Verbindung zu Keramik, erhalten wird.

8. Verfahren zur Herstellung eines Keramikbauteils nach einem der vorhergehenden Ansprüche, **dadurch gekennzeichnet, dass** der Abscheideschritt (E3) das gleichzeitige oder aufeinander folgende Abscheiden von mehreren unterschiedlichen zusätzlichen Elementen oder Verbindungen umfasst.

9. Verfahren zur Herstellung eines Keramikbauteils nach einem der vorhergehenden Ansprüche, **dadurch gekennzeichnet, dass** der Abscheideschritt (E3) das Zugeben mindestens eines zusätzlichen Elements oder einer zusätzlichen Verbindung zu einem gebundenen Keramikpulver umfasst, das eine organische Verbindung in einer Menge von 1 bis einschließlich 4 Gew.-% oder von 12 bis einschließlich 25 Gew.-% oder von 1 bis einschließlich 25 Gew.-% umfasst, oder zu einem Keramikpulver, das keine organische Verbindung umfasst.

10. Verfahren zur Herstellung eines Keramikbauteils nach einem der vorhergehenden Ansprüche, **dadurch gekennzeichnet, dass** es nach dem Abscheideschritt (E3) einen weiteren Abscheideschritt (E4) umfasst, der das Abscheiden mindestens eines weiteren zusätzlichen Elements oder einer weiteren zusätzlichen Verbindung, das bzw. die mit dem mindestens zusätzlichen Element oder der mindestens zusätzlichen Verbindung identisch oder davon verschieden ist, auf das Keramikpulver durch eine physikalische Gasphasenabscheidung (PVD) und/oder durch eine chemische Gasphasenabscheidung (CVD) und/oder durch eine Atomlagenabscheidung (ALD) umfasst.

11. Verfahren zur Herstellung eines Keramikbauteils nach einem der vorhergehenden Ansprüche, **dadurch gekennzeichnet, dass** es einen Schritt umfasst, der darin besteht, farbgebende Pigmente oder phosphoreszierende Pigmente zu dem Keramikpulver, gebunden oder nicht, vor oder nach einem Schritt des Abscheidens (E3) mindestens einer zusätzlichen Verbindung, insbesondere einer farbgebenden Verbindung, die verschieden von den anfänglich zugegebenen farbgebenden Pigmenten ist, zuzugeben.

12. Verfahren zur Herstellung eines Keramikbauteils nach einem der vorhergehenden Ansprüche, **dadurch gekennzeichnet, dass** es die folgenden Schritte umfasst:
- Beschaffen eines gebundenen Keramikpulvers, das farbgebende Pigmente oder allgemeiner mindestens eine zugegebene und/oder zusätzliche Verbindung enthält, die es ermöglichen würden, ein Keramikbauteil einer ersten Farbe oder allgemeiner ein Keramikbauteil, das mit einer ersten Eigenschaft ausgestattet ist, durch Herstellen eines Keramikbauteils aus diesem gebundenen Keramikpulver zu erhalten;
- Abscheiden (E3; E4) mindestens eines zusätzlichen Elements oder einer zusätzlichen Verbindung auf das gebundene Keramikpulver durch eine Atomlagenabscheidung (ALD);
- Abschließen der Herstellung des Keramikbauteils aus dem gebundenen Keramikpulver, das das abgeschiedene zusätzliche Element oder die abgeschiedene zusätzliche Verbindung enthält, um ein Keramikbauteil zu erhalten, dessen Farbe eine zweite Farbe ist, die von der ersten Farbe verschieden ist, oder das allgemeiner mit einer zweiten Eigenschaft ausgestattet ist, die von der ersten Eigenschaft verschieden ist.

13. Verfahren zur Herstellung eines Keramikbauteils nach dem vorhergehenden Anspruch, **dadurch gekennzeichnet, dass** es die Wiederholung von Schritten des Abscheidens mindestens eines zusätzlichen Elements oder einer zusätzlichen Verbindung auf das gebundene Keramikpulver umfasst, mit mehreren verschiedenen Abscheidungen mindestens einer zusätzlichen Verbindung, wobei die Menge und/oder die zusätzliche Verbindung geändert wird, bis man einer zweiten Farbe oder einer erwünschten zweiten Eigenschaft nach Abschluss der Herstellung des Keramikbauteils ausreichend nahe kommt.

14. Verfahren zur Herstellung eines Keramikbauteils nach Anspruch 12 oder 13, **dadurch gekennzeichnet, dass** es einen Schritt des Auswählens eines gebundenen Keramikpulvers umfasst, das mindestens eine Verbindung enthält, die es ermöglicht, eine erste Eigenschaft zu erhalten, die einer erwünschten zweiten Eigenschaft nahe kommt.

15. Verfahren zur Herstellung eines Keramikbauteils nach einem der Ansprüche 12 bis 14, **dadurch gekennzeichnet, dass** es ermöglicht, eine Uhrenlünette, ein Zifferblatt, einen Zeiger, eine Aufzugskrone, einen Drücker oder ein anderes Uhrausstattungselement oder ein anderes Element eines Uhrwerks herzustellen.

## Claims

1. A process for manufacturing a ceramic component for timepiece or jewellery part, **characterized in that** it comprises :
- a) a first phase (P1) consisting in preparing a ceramic powder, said ceramic powder being in particular based on zirconia and/or alumina and/or strontium aluminate,
- b) a deposition step (E3) comprising the deposition of at least one additional element or compound on said ceramic powder by an atomic layer deposition (ALD),
- c) a second phase (P2), before or after the deposition step (E3), consisting in integrating a binder of organic material type into the ceramic powder for forming a ceramic powder with binder,
and **characterized in that** then after the phases (P1) and (P2) of preparing a ceramic powder and integrating a binder and after the deposition step (E3) comprising the deposition of at least one additional element or compound, the manufacturing process carries out:
- d) a third phase (P3) of provisional shaping of the ceramic powder with binder comprising the at least one additional compound, then
- e) a fourth phase (P4) comprising a step of debinding the provisionally shaped ceramic component consisting in particular of the elimination of the organic compounds then a step of sintering the ceramic component.

2. The process for manufacturing a ceramic component as claimed in the preceding claim, **characterized in that** the deposition step (E3) comprises the addition of the at least one additional element or compound in a total amount in the ceramic powder, excluding possible organic compound(s), of less than or equal to 3% by weight, or less than or equal to 1% by weight, or less than or equal to 0.05% by weight, or less than or equal to 0.01% by weight excluding the organic compound(s).

3. The process for manufacturing a ceramic component as claimed in one of the preceding claims, **characterized in that** the deposition step (E3) comprises the addition of the at least one additional compound or element in a total amount of greater than or equal to 1 ppm, or greater than or equal to 10 ppm, excluding the organic compound(s).

4. The process for manufacturing a ceramic component as claimed in one of the preceding claims, **characterized in that** the deposition step (E3) comprises the deposition of an additional compound chosen from a metal, and/or a metal alloy, and/or an oxide, and/or a nitride and/or a carbide.

5. The process for manufacturing a ceramic component as claimed in the preceding claim, **characterized in that** the additional element or compound is or comprises at least one metal chosen from at least one of the following four lists:
- a noble metal with a high melting point, chosen from platinum, rhodium, osmium, palladium, ruthenium, or iridium, or
- any other metal chosen from gold, aluminium, silver, rhenium, titanium, tantalum or niobium, or
- a transition metal chosen from aluminium, iron, chromium, vanadium, manganese, cobalt, nickel or copper,
- a lanthanide chosen from lanthanum, cerium, praseodymium, neodymium, promethium, samarium, europium, gadolinium, terbium, dysprosium, holmium, erbium, thulium, ytterbium or lutetium.

6. The process for manufacturing a ceramic component as claimed in one of the preceding claims, **characterized in that** the additional compound is a metal alloy, obtained by the direct deposition of the metal alloy on the ceramic powder with or without binder or by the combination of successive or simultaneous depositions of several of the elements of the metal alloy or compound on the ceramic powder with or without binder.

7. The process for manufacturing a ceramic component as claimed in one of claims 1 to 6, **characterized in that** the additional compound or element is an oxide, a carbide or a nitride of one or more metals, obtained by the direct deposition of the oxide, carbide or nitride on the ceramic powder with or without binder or by the reaction of a metallic deposition with a reactive atmosphere, in particular in the deposition chamber or after the deposition, for example during a step of sintering the ceramic compound.

8. The process for manufacturing a ceramic component as claimed in one of the preceding claims, **characterized in that** the deposition step (E3) comprises the simultaneous or successive deposition of several different additional elements or compounds.

9. The process for manufacturing a ceramic component as claimed in one of the preceding claims, **characterized in that** the deposition step (E3) comprises the addition of at least one additional element or compound to a ceramic powder with binder, comprising an organic compound in an amount of between 1% and 4% inclusive by weight or between 12% and 25% inclusive by weight, or between 1% and 25% inclusive by weight, or to a ceramic powder comprising no organic compound.

10. The process for manufacturing a ceramic component as claimed in one of the preceding claims, **characterized in that** it comprises, after the deposition step (E3), another deposition step (E4) comprising the deposition of at least one other additional element or compound, identical to or different from said at least one additional element or compound, on said ceramic powder by a physical vapour deposition (PVD) and/or by a chemical vapour deposition (CVD) and/or by an atomic layer deposition (ALD);

11. The process for manufacturing a ceramic component as claimed in one of the preceding claims, **characterized in that** it comprises a step consisting in adding colouring pigments or phosphorescent pigments to the ceramic powder with or without binder, before or after a step (E3) of depositing at least one additional compound, in particular a colouring compound other than the colouring pigments added initially.

12. The process for manufacturing a ceramic component as claimed in one of the preceding claims, **characterized in that** it comprises the following steps:
- providing a ceramic powder with binder containing colouring pigments or more generally at least one added and/or additional compound that would make it possible to obtain a ceramic component of a first colour or more generally endowed with a first property, by manufacturing a ceramic component from this ceramic powder with binder;
- depositing (E3; E4) at least one additional element or compound on said ceramic powder with binder by an atomic layer deposition (ALD);
- completing the manufacture of the ceramic component from the ceramic powder with binder including the deposited additional element or compound in order to obtain a ceramic component, the colour of which is a second colour, different from the first colour, or more generally that is endowed with a second property, different from the first property.

13. The process for manufacturing a ceramic component as claimed in the preceding claim, **characterized in that** it comprises the repetition of steps of depositing at least one additional element or compound on said ceramic powder with binder, with several different depositions of at least one additional compound, by varying the amount and/or the additional compound, until it has come sufficiently close to a desired second colour or second property after completion of the manufacture of the ceramic component.

14. The process for manufacturing a ceramic component as claimed in claim 12 or 13, **characterized in that** it comprises a step of selecting a ceramic powder with binder containing at least one compound that makes it possible to obtain a first property that comes close to a desired second property.

15. The process for manufacturing a ceramic component as claimed in one of claims 12 to 14, **characterized in that** it makes it possible to manufacture a watch bezel, a dial, an index, a winding crown, a push button or any other horological casing element or any element of a horological movement.
